# EUROPÄISCHE PATENTSCHRIFT

(11) **EP 2 686 912 B1**
(45) Veröffentlichungstag und Bekanntmachung des Hinweises auf die Patenterteilung: **17.12.2014**
(21) Anmeldenummer: 12705116.7
(22) Anmeldetag: 17.02.2012
(51) Int. Cl.: H01R 13/15, H01R 13/26

(54) **DIREKTSTECKELEMENT MIT VERBESSERTER KONTAKTIERUNG**
DIRECT PLUG ELEMENT WITH IMPROVED CONTACT-CONNECTION
ÉLÉMENT D'ENFICHAGE DIRECT À CONNEXION ÉLECTRIQUE AMÉLIORÉE

(30) Priorität: 14.03.2011 DE 102011005482
(43) Veröffentlichungstag der Anmeldung: 22.01.2014
(73) Patentinhaber: Robert Bosch GmbH, 70442 Stuttgart (DE)
(72) Erfinder: REHBEIN, Peter, 97291 Thuengersheim (DE); SCHMATZ, Ulrich, 74354 Besigheim (DE)
(86) Internationale Anmeldenummer: PCT/EP2012/052781
(87) Internationale Veröffentlichungsnummer: WO 2012/123218

(56) Entgegenhaltungen:
- WO-A1-2006/013117
- DE-B- 1 081 098
- US-A- 4 040 713

## Beschreibung

### Stand der Technik

Die vorliegende Erfindung betrifft ein Direktsteckelement zur Kontaktierung eines elektrischen Kontaktes, welcher beispielsweise auf einer Leiterplatte freiliegend angeordnet ist, wobei das Direktsteckelement eine verbesserte Kontaktierung ermöglicht.

In jüngster Zeit werden vermehrt Direktsteckkontakte verwendet, bei denen ein Direktsteckelement unmittelbar auf eine Trägerplatte, z.B. eine Leiterplatte oder ein Stanzgitter, gesteckt wird. Durch die fortschreitende Miniaturisierung nehmen dabei die Leiterplatten, die beispielsweise in Steuergeräten von Fahrzeugen eingesetzt werden, ständig weniger Raum ein. Durch eine Direktsteckverbindung kann hierbei an der Steuergeräteseite zusätzlich ein Raumbedarf für einen Stecker reduziert werden. Insbesondere bei Automotive-Anwendungen muss jedoch ein sehr robuster Kontakt auch bei Verwendung von Direktsteckelementen möglich sein. WO 2006/013117 A1 ein Direktsteckelement gemäß dem Oberbegriff des Anspruchs 1.

### Offenbarung der Erfindung

Das erfindungsgemäße Direktsteckelement zur Kontaktierung eines elektrischen Kontaktes mit dem Merkmalen des Anspruches 1 weist dem gegenüber den Vorteil auf, dass es eine verbesserte Kontaktierung, insbesondere mit einer größeren Kontaktkraft, ermöglicht. Dabei ist die Kontaktierung zwischen dem Direktsteckelement und einem elektrischen Kontakt, der freiliegend z.B. an einer Leiterplatte angeordnet ist, sehr robust ausgeführt, so dass insbesondere eine Verwendung im Fahrzeugbereich problemlos möglich ist. Dies wird erfindungsgemäß dadurch erreicht, dass das Direktsteckelement einen zweiteiligen, federnden Direktkontakt mit einem ersten separaten Federelement und einem zweiten separaten Federelement umfasst. Dabei sind das erste und zweite Federelement in einer Kontaktrichtung hintereinander angeordnet und die Federkräfte der beiden Federelemente sind im Wesentlichen in die gleiche Richtung gerichtet. Dabei weist das zweite Federelement einen Kontaktbereich auf, welcher die Kontaktierung mit dem elektrischen Kontakt des Gegenstücks ausführt. Das Crimpelement fixiert das erste und zweite Federelement. Hierdurch kann eine sichere und einfache sowie konstengünstige Montage der beiden Federelemente erreicht werden.

Die Unteransprüche zeigen bevorzugte Weiterbildungen der Erfindung.

Besonders bevorzugt ist der Kontaktbereich am zweiten Federelement ein Punktkontakt. Der Punktkontakt kann besonders bevorzugt durch Prägen am zweiten Federelement hergestellt werden, so dass der Punktkontakt in Kontaktrichtung vorstehend gewölbt ist.

Gemäß einer weiteren bevorzugten Ausgestaltung der vorliegenden Erfindung sind das erste und zweite Federelement aus unterschiedlichen Materialien hergestellt und/oder das erste und zweite Federelement weisen unterschiedliche Beschichtungen auf. Hierdurch ist es möglich, dass beispielsweise ein aus Kupfer hergestelltes Federelement, welches relativ kraftschwach ist, durch ein zweites, separates Federelement aus Stahl überlagert wird. Hierdurch kann auf einfache und kostengünstige Weise eine größere Kontaktkraft des Direktkontaktes bereitgestellt werden. Vorzugsweise ist erfindungsgemäß das erste Federelement aus Stahl hergestellt. Es ist jedoch auch möglich, dass das zweite Federelement, welches die Kontaktierung ausführt, aus Stahl hergestellt ist. Dann muss das zweite Federelement allerdings aufgrund der begrenzten elektrischen Leitfähigkeit des Stahls mit einem Edelmetall, z.B. Gold, Silber, Palladium, Zinn oder dergleichen, beschichtet sein.

Besonders bevorzugt sind die beiden Federelemente derart vorgesehen, dass das erste Federelement das zweite Federelement im nicht montierten Zustand vorspannt. Hierdurch können gegebenenfalls auch größere Toleranzen am Direktsteckelement bzw. am Gegenstück ausgeglichen werden.

Besonders bevorzugt ist der Direktkontakt des Direktsteckelements derart ausgebildet, dass der Direktkontakt eine Federkraft in einer Kontaktrichtung zwischen 2 bis 4 Newton aufweist, ohne dass dabei eine plastische Deformation eines der Federelemente auftritt. Hierdurch kann eine im Vergleich mit dem Stand der Technik verdoppelte Kontaktkraft erreicht werden, ohne dass Beschädigungen am Direktkontakt auftreten.

Weiter bevorzugt sind das erste und/oder zweite Federelement aus einem Material mit einer Dicke von ungefähr 0,15 mm hergestellt. Das Material ist vorzugsweise ein Federblech.

Weiter bevorzugt ist das Crimpelement mit einem der Federelemente einstückig gebildet.

Ferner betrifft die vorliegende Erfindung eine elektrische Anordnung, umfassend eine Trägerplatte, insbesondere eine Leiterplatte, mit freiliegenden Kontaktbereichen und ein erfindungsgemäßes Direktsteckelement, welches die freiliegenden Kontaktbereiche direkt kontaktiert.

Das erfindungsgemäße Direktsteckelement wird vorzugsweise in Fahrzeugen, insbesondere zur Kontaktierung von Steuergeräten, verwendet.

### Zeichnung

Nachfolgend wird ein bevorzugtes Ausführungsbeispiel der Erfindung unter Bezugnahme auf die begleitende Zeichnung im Detail beschrieben. In der Zeichnung ist:
- Figur 1: eine schematische Seitenansicht eines Direktsteckelements gemäß einem Ausführungsbeispiel der Erfindung und
- Figur 2: ein Diagramm, welches die Federkraft über den Federweg darstellt.

### Bevorzugte Ausführungsform der Erfindung

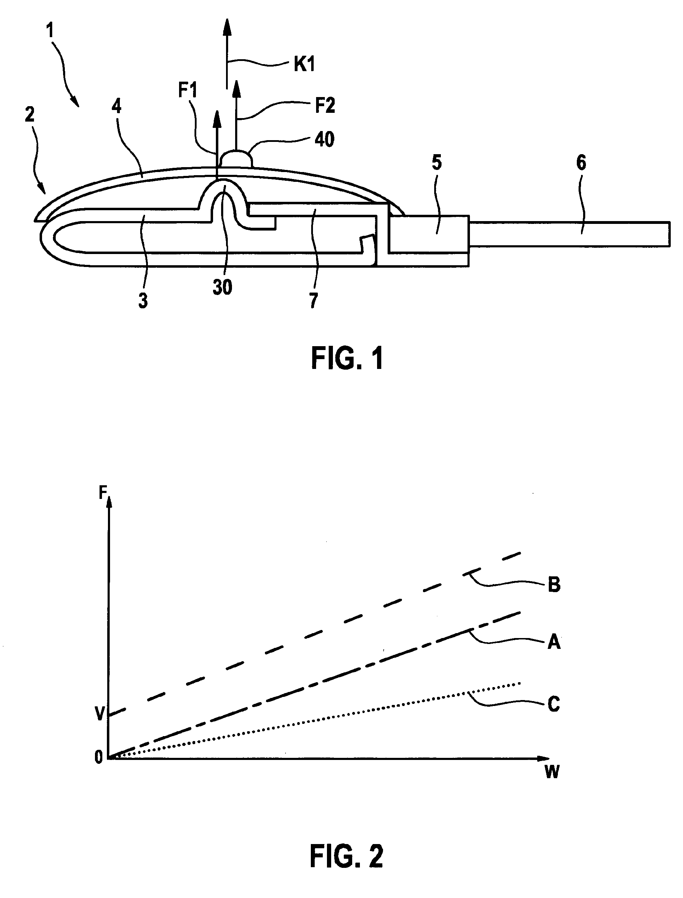

Nachfolgend wird unter Bezugnahme auf die Figuren 1 und 2 ein Direktsteckelement 1 gemäß einem bevorzugten Ausführungsbeispiel der Erfindung im Detail beschrieben.

Wie aus Figur 1 ersichtlich ist, umfasst das Direktsteckelement 1 einen Direktkontakt 2, welcher mittels eines Crimpelements 5 an einem Kabel 6 fixiert ist. Der Direktkontakt 2 umfasst ein erstes Federelement 3 und ein zweites Federelement 4. Beide Federelemente 3, 4 sind als separate Bauteile vorgesehen und werden durch das gemeinsame Crimpelement 5 fixiert und in elektrischen Kontakt mit dem Kabel 6 gebracht. Ferner ist ein Anschlag 7 vorgesehen, welcher das erste Federelement 3 in einer definierten Ausgangslage hält. Figur 1 zeigt dabei den nicht montierten Zustand des Direktsteckelements.

Wie weiter aus Figur 1 ersichtlich ist, umfasst das zweite Federelement 4 einen Kontaktbereich 40, über welchen die Kontaktierung mit einem nicht gezeigten, freiliegenden elektrischen Kontakt, beispielsweise einer Leiterplatte, ermöglicht wird. Der Kontaktbereich 40 ist vorzugsweise durch Ausprägen einstückig am zweiten Federelement 4 gebildet. Das erste Federelement 3 weist ferner einen eigenen Federbereich 30 auf, welcher in dem in Figur 1 gezeigten Ausführungsbeispiel keine Vorspannkraft auf das zweite Federelement 4 ausübt. Es sei jedoch angemerkt, dass die Ausgestaltung des Direktkontaktes 2 auch derart sein kann, dass das erste Federelement 3 eine Vorspannkraft auf das zweite Federelement 4 ausübt.

In diesem Ausführungsbeispiel ist das zweite Federelement 4 aus Kupfer oder einer Kupferlegierung hergestellt und das erste Federelement 3 aus einem Stahlmaterial. Hierdurch ist für den elektrischen Kontakt keine Beschichtung eines der Federelemente notwendig.

In Figur 1 ist durch den Pfeil K1 eine Kontaktrichtung des Direktkontakts 2 eingezeichnet. Dabei sind das erste Federelement 3 und das zweite Federelement 4 in der Kontaktrichtung K1 hintereinander angeordnet. Hierdurch addieren sich eine Federkraft F1 des ersten Federelements 3 und eine Federkraft F2 des zweiten Federelements 4 im montierten Zustand, so dass eine insgesamt vergrößerte Federkontaktkraft auf einen elektrischen Kontakt ausgeübt werden kann. Erfindungsgemäß kann dabei eine Kontaktkraft von 2 bis 4 Newton in der Kontaktrichtung K1 erreicht werden. Somit weist die erfindungsgemäße Kontaktkraft bei gleichem Federweg eine ungefähr doppelt so große Größe wie eine Kontaktkraft des Standes der Technik auf.

Wie aus dem Diagramm von Figur 2 ersichtlich ist, weist das erfindungsgemäße Direktsteckelement dabei über dem Federweg W eine signifikant größere Federkraft F auf. Die mit A gekennzeichnete Kurve zeigt dabei die Federkennlinie des erfindungsgemäßen Direktkontakts ohne Vorspannung. Die mit B gekennzeichnete Linie zeigt dabei eine Federkennlinie des Direktkontakts mit einer Vorspannung V. D.h., bei der Kennlinie B übt das erste Federelement 3 eine Vorspannung V auf das zweite Federelement 2 im nicht montierten Zustand aus. Zum Vergleich ist in Figur 2 ferner noch die Federkennlinie des Standes der Technik eingezeichnet, welche lediglich ein einziges Federelement C verwendet.

Es sei ferner angemerkt, dass das zweite Federelement 4 insbesondere auch einstückig mit dem Crimpelement 5 gebildet sein kann. Hierdurch kann die Anzahl der Einzelteile reduziert werden. Alternativ kann auch das erste Federelement 3 und das Crimpelement 5 einstückig gebildet sein. Weiter alternativ kann auch der Anschlag 7 einstückig mit dem Crimpelement 5 gebildet sein. Weiter alternativ können auch beide Federelemente 3, 4 aus Stahl hergestellt sein, wobei dann das zweite Federelement 4 eine Beschichtung, z.B. aus Gold, Silber, Palladium oder Zinn, für eine verbesserte elektrische Leitfähigkeit aufweist.

Das erfindungsgemäße Direktsteckelement wird vorzugsweise in Steuergeräten von Fahrzeugen verwendet.

## Patentansprüche

1. Direktsteckelement zur Kontaktierung eines elektrischen Kontaktes, umfassend
- einen zweiteiligen, federnden Direktkontakt (2) mit
- einem ersten, separaten Federelement (3) und
- einem zweiten, separaten Federelement (4),
- wobei das erste Federelement (3) und das zweite Federelement (4) in einer Kontaktrichtung (K1) hintereinander angeordnet sind,
- wobei eine erste Federkraft (F1) des ersten Federelements und eine zweite Federkraft (F2) des zweiten Federelements im Wesentlichen in die gleiche Richtung gerichtet sind und
- wobei das zweite Federelement (4) einen Kontaktbereich (40) aufweist,
**dadurch gekennzeichnet, dass**
das Direktsteckelement ein Crimpelement (5) umfasst, wobei das Crimpelement (5) das erste und zweite Federelement (3, 4) fixiert.

2. Direktsteckelement nach Anspruch 1, **dadurch gekennzeichnet, dass** der Kontaktbereich (40) des zweiten Federelements (4) ein Punktkontakt ist.

3. Direktsteckelement nach Anspruch 2, **dadurch gekennzeichnet, dass** der Punktkontakt aus dem zweiten Federelement (4) ausgeprägt ist.

4. Direktsteckelement nach einem der vorhergehenden Ansprüche, **dadurch gekennzeichnet, dass** das erste und zweite Federelement aus unterschiedlichen Materialien hergestellt sind und/oder dass das erste und zweite Federelement unterschiedliche Beschichtungen aufweisen.

5. Direktsteckelement nach einem der vorhergehenden Ansprüche, **dadurch gekennzeichnet, dass** das erste Federelement (3) das zweite Federelement (4) in einem nicht montierten Zustand mittels einer Vorspannkraft (V) vorspannt.

6. Direktsteckelement nach einem der vorhergehenden Ansprüche, **dadurch gekennzeichnet, dass** der Direktkontakt (2) in Kontaktrichtung (K1) eine Federkraft aufweist, welche in einem Bereich von 2 bis 4 Newton liegt.

7. Direktsteckelement nach einem der vorhergehenden Ansprüche, **dadurch gekennzeichnet, dass** das erste Federelement (3) und/oder das zweite Federelement (4) aus einem Material mit einer Dicke von 0,15 mm hergestellt ist, insbesondere aus einem Federblech.

8. Direktsteckelement nach einem der vorhergehenden Ansprüche, **dadurch gekennzeichnet, dass** das Crimpelement (5) mit einem der Federelemente (3, 4), insbesondere mit dem zweiten Federelement, einstückig gebildet ist.

9. Elektrische Anordnung, umfassend eine Trägerplatte, insbesondere eine Leiterplatte, mit freilegenden Kontaktbereichen und ein Direktsteckelement nach einem der vorhergehenden Ansprüche.

## Claims

1. Direct plug-in element for making contact with an electrical contact, comprising
- a two-part, spring-action direct contact (2) having
- a first, separate spring element (3) and
- a second, separate spring element (4),
- wherein the first spring element (3) and the second spring element (4) are arranged one behind the other in a contact direction (K1),
- wherein a first spring force (F1) of the first spring element and a second spring force (F2) of the second spring element are directed substantially in the same direction, and
- wherein the second spring element (4) has a contact region (40),
**characterized in that**
the direct plug-in element comprises a crimping element (5), wherein the crimping element (5) fixes the first and the second spring element (3, 4).

2. Direct plug-in element according to Claim 1, **characterized in that** the contact region (40) of the second spring element (4) is a point contact.

3. Direct plug-in element according to Claim 2, **characterized in that** the point contact is formed from the second spring element (4).

4. Direct plug-in element according to one of the preceding claims, **characterized in that** the first and the second spring element are produced from different materials, and/or **in that** the first and the second spring element have different coatings.

5. Direct plug-in element according to one of the preceding claims, **characterized in that** the first spring element (3) prestresses the second spring element (4) by means of a prestress force (V) in an unassembled state.

6. Direct plug-in element according to one of the preceding claims, **characterized in that** the direct contact (2) has a spring force in the contact direction (K1), the said spring force lying in a range of from 2 to 4 Newtons.

7. Direct plug-in element according to one of the preceding claims, **characterized in that** the first spring element (3) and/or the second spring element (4) are/is produced from a material with a thickness of 0.15 mm, in particular from a spring sheet.

8. Direct plug-in element according to one of the preceding claims, **characterized in that** the crimping element (5) is integrally formed with one of the spring elements (3, 4), in particular with the second spring element.

9. Electrical arrangement, comprising a mounting board, in particular a printed circuit board, having exposed contact regions and a direct plug-in element according to one of the preceding claims.

## Revendications

1. Élément d'enfichage direct pour la mise en contact d'un contact électrique, comportant
- un contact direct élastique en deux parties (2) comprenant
- un premier élément ressort séparé (3) et
- un deuxième élément ressort séparé (4),
- le premier élément ressort (3) et le deuxième élément ressort (4) étant disposés l'un derrière l'autre dans un sens de contact (K1),
- une première force de ressort (F1) du premier élément ressort et une deuxième force de ressort (F2) du deuxième élément ressort étant orientées essentiellement dans le même sens et
- le deuxième élément ressort (4) comprenant une zone de contact (40),
**caractérisé en ce que**
l'élément d'enfichage direct comporte un élément de sertissage (5), l'élément de sertissage (5) fixant le premier et le deuxième élément ressort (3, 4).

2. Élément d'enfichage direct selon la revendication 1, **caractérisé en ce que** la zone de contact (40) du deuxième élément ressort (4) est un contact ponctuel.

3. Élément d'enfichage direct selon la revendication 2, **caractérisé en ce que** le contact ponctuel est estampé dans le deuxième élément ressort (4).

4. Élément d'enfichage direct selon l'une quelconque des revendications précédentes, **caractérisé en ce que** le premier et le deuxième élément ressort sont fabriqués à partir de matériaux différents et/ou en ce que le premier et le deuxième élément ressort présentent des revêtements différents.

5. Élément d'enfichage direct selon l'une quelconque des revendications précédentes, **caractérisé en ce que** le premier élément ressort (3) précontraint le deuxième élément ressort (4) dans un état non monté au moyen d'une force de précontrainte (V).

6. Élément d'enfichage direct selon l'une quelconque des revendications précédentes, **caractérisé en ce que** le contact direct (2) présente une force de ressort dans le sens de contact (K1), laquelle se situe dans une plage de 2 à 4 Newton.

7. Élément d'enfichage direct selon l'une quelconque des revendications précédentes, **caractérisé en ce que** le premier élément ressort (3) et/ou le deuxième élément ressort (4) est/sont fabriqué(s) à partir d'un matériau présentant une épaisseur de 0,15 mm, en particulier à partir d'une tôle à ressort.

8. Élément d'enfichage direct selon l'une quelconque des revendications précédentes, **caractérisé en ce que** l'élément de sertissage (5) est formé d'une seule pièce avec l'un des éléments ressort (3, 4), en particulier avec le deuxième élément ressort.

9. Agencement électrique, comportant une carte de support, en particulier une carte à circuits imprimés, comprenant des zones de contact exposées et un élément d'enfichage direct selon l'une quelconque des revendications précédentes.
